# DEMANDE DE BREVET EUROPEEN

(11) **EP 2 784 780 A2**
(43) Date de publication de la demande: **01.10.2014**
(21) Numéro de dépôt: 14161848.8
(22) Date de dépôt: 26.03.2014
(51) Int. Cl.: G11B 33/12, G11B 33/14, H05K 7/14, H05K 7/20

(54) **Rack destiné à équiper une plateforme aéronautique**

(30) Priorité: 27.03.2013 FR 1300709
(71) Demandeur: Thales, 92200 Neuilly Sur Seine (FR)
(72) Inventeur: Sarno, Claude, 26800 ETOILE-SUR-RHONE (FR); Oconte, Philippe, 26250 LIVRON-SUR-DROME (FR); Morlet, François, 07500 GUILHERAND-GRANGES (FR)
(74) Mandataire: Collet, Alain

(57) **Abrégé**

L'invention concerne un rack destiné à équiper une plateforme aéronautique (10) comprenant deux étagères (11, 12) parallèles disposées entre une face avant (13) et une face arrière (14) de la plateforme (10), le rack (15) étant destiné à être inséré dans la plateforme (10) par translation (16) de la face avant (13) vers la face arrière (14), le rack (15) contenant au moins un équipement électronique (18) s'étendant principalement dans un plan, l'équipement électronique (18) étant disposé dans un compartiment utile (17) du rack (15), l'équipement électronique (18) étant refroidi par convection forcée. Selon l'invention, l'équipement électronique (18) est disposé dans le compartiment utile (15) de telle sorte que son plan principal soit parallèle aux étagères (11, 12). L'équipement électronique (18) peut s'enficher dans le rack (15) selon la même direction que la direction (16) d'insertion du rack (15) dans la plateforme (10). Le rack (15) comprend des moyens de guidage (22, 38) d'un flux d'air utilisé pour le refroidissement de l'équipement électronique (18), le flux d'air pénétrant dans le compartiment utile (17) parallèlement au plan de l'équipement électronique (18) et perpendiculairement à la direction (16) d'insertion du rack (15) dans la plateforme (10).

## Description

L'invention concerne un rack destiné à équiper une plateforme aéronautique. Un objectif de l'invention est d'améliorer le refroidissement d'équipements électroniques portés par des baies embarquées ou montés isolément de façon autonome à bord d'aéronefs et situés dans des zones exigües.

A bord d'aéronefs les équipements électroniques peuvent provenir de différentes entreprises chacune spécialiste d'un domaine. Des normes ont été développées pour permettre le montage physique des différents équipements à bord d'un même porteur. A titre d'exemple, on peut citer le standard ARINC 600 définissant une conception modulaire basée sur des équipements pouvant être montés à bord d'aéronefs. Ces équipements sont bien connus dans la littérature anglo-saxonne sous le nom de « Modular Concept Unit (MCU) » pour unités de conception modulaire. Le standard ARINC 600 prévoit des hauteurs standardisées pour les racks. Les baies ou meubles destinées à recevoir ces racks, bien que n'étant pas standardisés sont développés en conséquence. Dans ces baies ou meubles, la hauteur séparant deux étagères superposées ou deux étages de la même étagère est de 194 mm. Le rack forme un MCU. On rappelle qu'ARINC (Aeronautical Radio, Incorporated) est une société américaine dont le siège social est situé à Annapolis, dans le Maryland. Cette société est connue pour définir les principaux standards de communications à l'intérieur des aéronefs et entre les aéronefs et le sol.

Dans les racks équipant classiquement les baies ARINC 600, des cartes électroniques sont disposées verticalement. Pour le refroidissement des cartes, une convection forcée d'air peut être prévue verticalement entre les cartes. Le flux d'air utilisé pour le refroidissement peut être amené vers le rack par un conduit réalisé dans une étagère de la baie sur laquelle est posé le rack. Un prélèvement d'air est directement réalisé par la face inférieure du rack afin de circuler entre les cartes.

D'autres standards plus récents tendent à se développer, comme par exemple le standard EIA-310, qui définit des formats dont la hauteur est exprimée en unité de rack. Une unité (1 U) correspond à 1,75 pouce, c'est à dire 44,45 mm. Par exemple des cartes électroniques destinées à équiper des racks 6U ont des dimensions de 233,35 x 160 mm. EIA (Electronic Industries Alliance) est une organisation regroupant des fabricants et des utilisateurs d'équipements électroniques. Son siège est situé aux Etats-Unis à Arlington (Virginia). Toujours à titre d'exemple, on peut citer le standard VITA développé à partir des bus VME et dont le siège social est situés aux Etats-Unis à Fountain Hills (Arizona). Il est bien entendu que l'invention peut être mise en oeuvre dans tout type de carte développée selon un standard différent de celui mis en oeuvre pour le développement des emplacements destinés à recevoir ces cartes. Cette problématique est courante lorsque l'on souhaite intégrer de nouvelles technologies dans des équipements plus anciens. Ce type d'intégration est connu dans la littérature anglo-saxonne sous le nom de « retrofit ».

Pour revenir à l'exemple du standard EIA-310, il serait souhaitable de pouvoir installer des racks 6U dans des baies de type ARINC 600 afin de profiter de développements faits selon l'architecture 6U pour mettre à niveau des avions dont les baies ont été conçues selon l'architecture ARINC 600 sans modifier les baies. Cela permet de ne remplacer que certains racks tout en conservant d'autres racks d'origine. Mais les racks développés au format 6U ne peuvent pas directement prendre place dans des baies de type ARINC 600.

Tout d'abord, afin de conserver le mode de refroidissement développé dans le standard ARINC 600, les cartes devraient être placées verticalement. Il n'est pas possible de placer le grand côté des cartes développées au format 6U entre deux étagères d'une baie de type ARINC 600. En effet, la longueur de 233,25mm d'une carte au format 6U est supérieure à la distance de 194mm séparant deux étagères de type ARINC 600. On peut néanmoins placer le petit coté des cartes verticalement. Néanmoins cette disposition présente plusieurs inconvénients. Tout d'abord, le rack peut déborder de la face avant des étagères ce qui peut poser des problèmes d'encombrement. Ensuite la connectique des cartes est souvent placée sur leur grand coté ce qui complique fortement l'enfichage des cartes dans le rack. Il est alors nécessaire d'extraire le rack pour atteindre les cartes, ce qui pose des problèmes de longueur de câble.

Une autre solution consiste à placer les cartes de façon horizontales. On peut être dissuadé de mettre oeuvre cette disposition du fait de la difficulté à réaliser un refroidissement correct des cartes horizontales par un flux d'air vertical car la carte la plus basse empêche le flux d'air d'accéder aux cartes situées au dessus.

L'invention permet de dépasser ce préjugé en assurant le refroidissement de cartes montées horizontalement. L'invention permet l'installation de rack contenant des cartes de type 6U dans une baie de type ARINC 600. L'invention n'est pas limitée à ces deux standards et de façon plus générale l'invention a pour but de permettre l'installation de racks contenant des cartes définies selon un premier format dans une baie définie pour recevoir des racks selon un second format, les cartes du premier format étant plus grande que celle du second format. Pour assurer un fonctionnement correct des racks du premier format l'invention a pour objet un système de refroidissement du rack du premier format compatible avec les baies du second format.

A cet effet, l'invention a pour objet un rack destiné à équiper une plateforme comprenant deux étagères parallèles disposées entre une face avant et une face arrière de la plateforme, le rack étant destiné à être inséré dans la plateforme par translation de la face avant vers la face arrière, le rack contenant au moins un équipement électronique s'étendant essentiellement dans un plan, l'équipement électronique étant disposé dans un compartiment utile du rack, l'équipement électronique étant refroidi par convection forcée, caractérisé en ce que l'équipement électronique est disposé dans le compartiment utile de telle sorte que son plan soit parallèle aux étagères, en ce que l'équipement électronique peut s'enficher dans le rack selon la même direction que la direction d'insertion du rack dans la plateforme et en ce que le rack comprend des moyens de guidage d'un flux d'air utilisé pour le refroidissement de l'équipement électronique, le flux d'air pénétrant dans le compartiment utile parallèlement au plan de l'équipement électronique et perpendiculairement à la direction d'insertion du rack dans la baie.

L'invention sera mieux comprise et d'autres avantages apparaîtront à la lecture de la description détaillée d'un mode de réalisation donné à titre d'exemple, description illustrée par le dessin joint dans lequel :
la figure 1 représente de façon schématique en perspective un exemple de réalisation d'un rack selon l'invention dans son environnement ;
la figure 2 représente le rack en perspective éclatée ;
les figures 3, 4, 5 et 6 représentent une variante de moyens de guidage d'air de refroidissement du rack ;
la figure 7 représente une variante dans laquelle un flux d'air de refroidissement du rack provient du dessous du rack ;
la figure 8 représente une variante dans laquelle deux ventilateurs permettent d'entrainer le flux d'air utilisé pour le refroidissement du rack.

Par souci de clarté, les mêmes éléments porteront les mêmes repères dans les différentes figures.

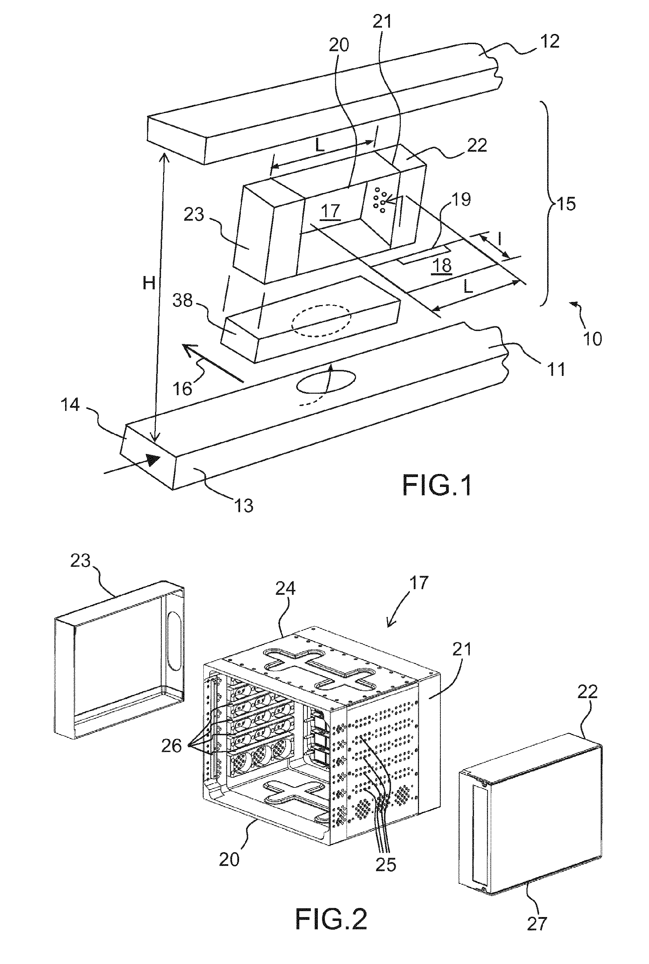

La figure 1 représente une baie 10 comprenant deux étagères planes 11 et 12 parallèles entre elles. Pour mieux comprendre la disposition des différents constituants de l'invention, une distance H séparant les deux étagères 11 et 12 a été dilatée sur la figure 1. Habituellement les deux étagères 11 et 12 sont disposées horizontalement et la distance H est mesurée verticalement. Néanmoins il est possible de mettre en oeuvre l'invention pour d'autres dispositions d'étagères, par exemple des étagères verticales.

On définit une face avant 13 et une face arrière 14 de la baie 10. Les deux faces 13 et 14 sont perpendiculaires aux plans des étagères 11 et 12.

Un rack 15 est monté dans la baie 10 entre les deux étagères 11 et 12. Le montage du rack 15 se fait par translation dans une direction matérialisée sur la figure 1 par une flèche 16. Cette direction est perpendiculaire aux faces 13 et 14. L'insertion du rack 15 se fait de la face avant 13 vers la face arrière 14.

L'exemple représenté montre un rack monté dans une baie. Il est bien entendu possible de monter un rack conforme à l'invention de façon autonome hors d'une baie pouvant habituellement contenir d'autres équipements électroniques. Un exemple de baie peut être appelé « baie avionique » par certains constructeurs d'avions. On pourra utiliser le terme « plateforme » pour englober tout contenant possible d'un rack selon l'invention. La plateforme pouvant donc être une baie, un meuble ou un simple emplacement prévu pour recevoir le rack.

Le rack 15 forme un contenant dans lequel sont disposés un ou plusieurs équipements électroniques. Le rack 15 comprend un compartiment utile 17 et des modules de servitude qui seront détaillés ultérieurement. Les équipements électroniques sont situés dans le compartiment utile 17. Les modules de servitudes permettent de réaliser des fonctions annexes distinctes des fonctions remplies par les équipements électroniques. Parmi les fonctions annexes, on s'intéresse plus particulièrement au refroidissement des équipements électroniques.

Les équipements électroniques s'étendent essentiellement chacun dans un plan. Un équipement électronique est par exemple formé de composants électroniques portés par une carte de circuit imprimé. On appelle couramment ce type d'équipement : carte électronique. Le plan du circuit imprimé forme alors le plan principal de l'équipement électronique. On peut également assembler des composants sur un support n'assurant pas le raccordement des composants entre eux, raccordement réalisé alors par câblage filaire. Ce type d'équipement s'étend également selon un plan principal par exemple formé d'une tôle métallique sur laquelle sont fixés des composants.

Les équipements électroniques sont disposés dans le compartiment utile 17 de telle sorte que leur plan soit parallèle aux étagères 11 et 12. Les équipements électroniques sont montés dans le rack 15 par enfichage selon la direction 16. A titre d'exemple, un équipement électronique 18 est représenté sur la figure 1. Avantageusement, l'équipement électronique 18 comprend un connecteur 19 de fond de panier disposé de sorte que sa direction d'insertion soit la direction 16. Le connecteur 19 assure le raccordement électrique de l'équipement vers d'autres équipements du rack 15, de la baie 10 ou encore vers l'extérieur de la baie 10. La position du connecteur 19 permet de réaliser en une seule opération à la fois le montage mécanique de l'équipement 18 et son raccordement électrique. Cette opération consiste dans l'enfichage de l'équipement 18 dans le rack 15 par translation dans la direction 16.

Les équipements électroniques 18 peuvent avoir une forme rectangulaire dans leur plan. Par exemple dans le format 6U, les équipements ont des dimensions hors tout mesurées dans leur plan de 233,35 x 160 mm, formant respectivement une longueur L et une largeur l de l'équipement électronique 18. Afin d'augmenter le nombre de points de connexion de l'équipement électronique 18, il est préférable de disposer le connecteur 19 sur le grand coté du rectangle. On peut par exemple utiliser des connecteurs possédant de l'ordre de 1000 points de connexion. Afin de mettre en place un rack au format 6U dans une baie au format ARINC 600, dont les étagères horizontales sont distantes d'une hauteur H de 194 mm, il serait possible de disposer les équipements 18 verticalement sur leur tranche en positionnant verticalement la largeur de 160 mm. Cette disposition permet de faciliter le refroidissement des équipements électroniques 18. En effet, dans une disposition verticale, une convection naturelle d'air se met en place en complément d'une convection forcée. C'est aussi la disposition retenue pour les racks au format ARINC 600. Néanmoins, une disposition verticale des équipements au format 6U dans la baie au format ARINC 600 conduit à positionner les connecteurs 19 allongés contre une étagère. L'insertion des équipements se fait alors verticalement et surtout perpendiculairement à la direction 16 d'insertion des racks 15 dans la baie 10. Cette disposition complique le raccordement électrique des équipements. En effet, pour enficher ou désenficher un équipement, il est nécessaire de sortir le rack de la baie, en le faisant coulisser dans la direction 16 pour pouvoir accéder à l'équipement. Le connecteur de la baie complémentaire du connecteur 19 de l'équipement doit être placé en extrémité d'un câble dont la longueur permet le coulissement du rack hors des étagères. En revanche dans la disposition de l'invention, c'est-à-dire en conservant la même direction pour l'insertion du rack 15 dans la baie 10 et pour l'insertion des équipements 18 dans le rack 15, on peut conserver le connecteur complémentaire fixe dans la baie 10 lors du montage ou du démontage d'un équipement. Cela permet de réduire les longueurs de câble de la baie. Cette réduction de longueur de câble permet de réduire le poids embarqué dans un aéronef équipé de la baie 10. De plus, une opération de maintenance consistant à remplacer un équipement 18 est simplifiée. Grâce à l'invention, il n'est pas nécessaire de sortir le rack 15 de la baie 10 pour accéder à l'équipement 18.

Le positionnement du plan principal des équipements 18 parallèlement au plan des étagères peut bien entendu être mis en oeuvre pour d'autres standards que les standards, ARINC 600 pour la baie 10 et 6U pour les équipements 18. De façon plus générale, une longueur hors tout L de l'équipement électronique 18 mesurée perpendiculairement à la direction d'insertion 16 peut être supérieure à une hauteur hors tout H du rack 15 mesurée perpendiculairement aux deux étagères 12 et 13.

Plus haut, la hauteur H a été définie comme la distance séparant les deux étagères 11 et 12. Par commodité la hauteur H est également utilisée pour la hauteur correspondante du rack 15. Il est bien entendu que des jeux fonctionnels sont prévus pour permettre l'insertion du rack 15 dans la baie 10. Il peut également être prévu un jeu pour permettre à l'air de circuler librement. Néanmoins, les hauteurs nominales du rack 15 et entre étagères 12 et 13 sont avantageusement identiques afin d'occuper au mieux l'espace disponible entre deux étagères 11 et 12.

Le rack 15 et le ou les équipements électroniques 18 qu'il contient sont refroidis par convection forcée d'air circulant le long des équipements 18. Autrement dit, dans le compartiment utile 17, la circulation de l'air de refroidissement se fait parallèlement aux plans principaux des équipements électroniques 18. Lorsque les étagères sont horizontales, les équipements 18 le sont aussi. Le rack 15 comprend des moyens de guidage du flux d'air utilisé pour le refroidissement équipements électroniques 18. Le flux d'air pénètre dans le compartiment utile 17 parallèlement aux plans des équipements électroniques 18 et perpendiculairement à la direction 16 d'insertion du rack 15 dans la baie 10.

Il est possible de faire pénétrer dans le compartiment utile 17 le flux d'air de refroidissement de l'équipement électronique 18 par une face avant 20 du rack 15, la face avant 20 étant parallèle à la face avant 13 de la baie 10. La face avant 20 forme également la face d'insertion de l'équipement électronique 18 dans le rack 15. Mais avantageusement, le flux d'air pénètre dans le compartiment utile 17 par une face latérale 21 du compartiment utile 17, la face latérale 21 étant perpendiculaire à la face avant 20 et au plan des étagères 11 et 12. Cette disposition de l'arrivée d'air dans le compartiment utile 17 permet de positionner des moyens de guidage du flux d'air entre la face avant 13 et la face arrière 14 de la baie 10. Ainsi il est possible de maintenir les moyens de guidage du flux d'air complètement dans un volume défini entre les deux faces 11 et 12 de la baie 10.

Dans une disposition particulière les moyens de guidage comprennent avantageusement une boîte d'entrée 22 recouvrant une première face latérale 21 du compartiment utile 17. La boîte d'entrée 22 assure le guidage du flux d'air vers le compartiment utile 17. La boîte d'entrée 22 est par exemple parallélépipédique. Une des faces du parallélépipède est formée par la face latérale 21 du compartiment utile 17. La boîte d'entrée 22 comprend une entrée d'air qui peut être positionnée sur toute face du parallélépipède autre que la face la latérale 21 et une sortie d'air formée par la face latérale 21. La boîte d'entrée 22 est fermée hormis ses entrée et sortie d'air. Le fait d'utiliser une boîte fermée permet d'utiliser le volume intérieur de la boîte d'entrée 22 comme chambre de tranquillisation et éventuellement de répartition de l'air avant de pénétrer dans le compartiment utile 17. Ainsi on limite le risque d'éventuelles turbulences d'air en amont de l'orifice de sortie de la boîte d'entrée 22. Ces turbulences pourraient modifier la circulation du flux d'air dans le compartiment utile 17. La boîte d'entrée 22 peut contenir des répartiteurs permettant d'éviter une trop grande dispersion du flux d'air entre les équipements 18 situées à proximité de l'entrée d'air et ceux qui en sont éloignés.

La figure 2 représente en perspective éclatée le compartiment utile 17, la boîte d'entrée 22 et une boîte de sortie 23 recouvrant une seconde face latérale 24 du compartiment utile 17. La face latérale 24 est parallèle à la face latérale 21. La boîte de sortie 23 assure le guidage du flux d'air quittant le compartiment utile 17. A titre d'alternative, il est possible de se passer de boîte de sortie et par exemple de laisser sortir le flux d'air de refroidissement du compartiment utile 17 directement vers l'extérieur par la face latérale 24 ou même par la face avant 20 du rack 15. La présence d'une boîte de sortie 23 permet néanmoins de mieux maitriser le flux d'air en sortie du compartiment utile 17.

La sortie du flux d'air par la boîte de sortie 23 impose que les faces avant et arrière du compartiment possèdent un niveau d'étanchéité compatible avec le refroidissement des équipements électroniques 18. Au niveau de la face avant 20, chacun des équipements 18 peut posséder une plaque. Les plaques des différents équipements 18 forment, une fois assemblée dans le rack 15, la face avant 20. On peut également utiliser une porte assurant cette étanchéité.

Comme la boîte d'entrée 22, la boîte de sortie 23 est par exemple parallélépipédique. Une des faces du parallélépipède est formée par la face latérale 24 du compartiment utile 17. La boîte de sortie 23 comprend une entrée d'air formée par la face latérale 24 et une sortie d'air qui peut être positionnée sur toute face du parallélépipède autre que la face la latérale 24 selon les contraintes d'installation de la baie 10.

De façon à permettre le passage du flux d'air de la boîte d'entrée 22 vers le compartiment utile 17, les moyens de guidage comprennent par exemple des perçages 25 réalisés dans la face latérale 21 du compartiment utile 17.

Les deux faces latérales 21 et 24 peuvent servir de support pour le ou les équipements électroniques 18. Pour faciliter l'insertion des équipements électroniques 18, les deux faces latérales 21 et 24 peuvent comprendre des glissières 26 dans lesquelles coulissent les équipements 18 lors de leur insertion dans le compartiment utile 17. Lorsque les équipements 18 sont des cartes électroniques les circuits imprimés peuvent coulisser dans des guides cartes appartenant aux faces latérales 21 et 24 ou rapportés sur ces faces. Sur la figure 2 seules les glissières 26 de la face latérale 24 sont visibles. La face latérale 21 comprend des glissières 26 symétriques. Les perçages 25 sont réalisés entre les glissières 26 de la face latérale 21.

Parmi les équipements électroniques 18 montés dans le rack 15 certains peuvent nécessiter plus de refroidissement que d'autres, et on peut être amené à définir une répartition du flux d'air en fonction des besoins de chacun des équipements 18. Les perçages 25 sont alors avantageusement définis en fonction de la répartition souhaitée du flux d'air dans le compartiment utile 17.

La face latérale 24 peut également comprendre des perçages semblables aux perçages 25 de façon à permettre le passage du flux d'air du compartiment utile 17 vers la boîte de sortie 23.

Alternativement, le passage du flux d'air de la boîte d'entrée 22 vers le compartiment utile 17 peut se faire au travers des glissières 26 de la face 21. De même, l'air peut quitter le compartiment utile 17 au travers des glissières 26 de la face 24. Les moyens de guidage du flux d'air utilisé pour le refroidissement du ou des équipements électroniques 18 sont alors en partie contenu dans le ou les équipements 18 eux mêmes.

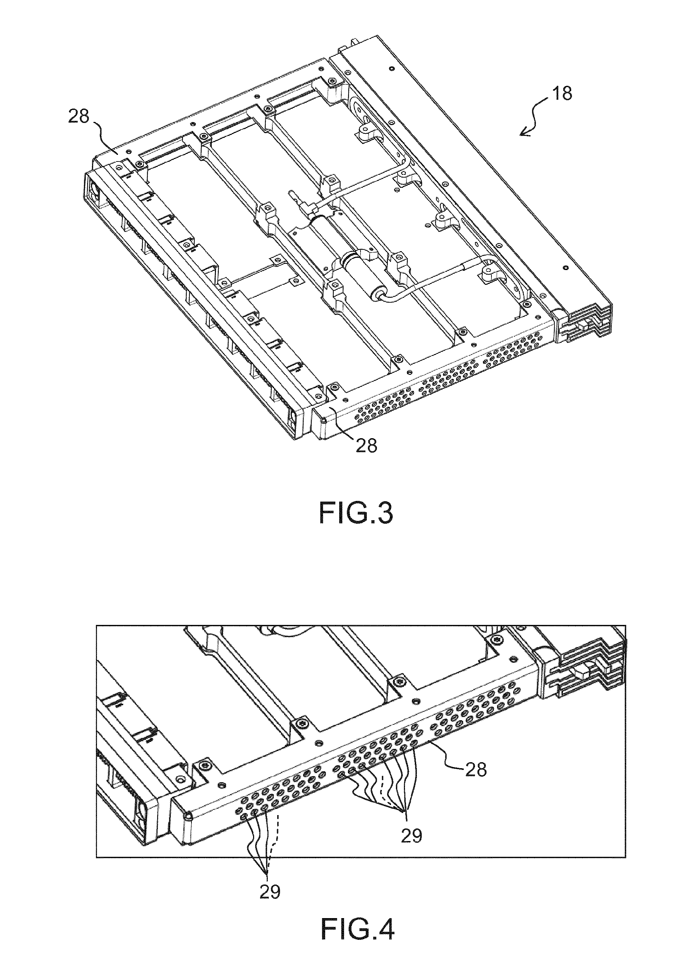

Cette variante est illustrée sur les figures 3, 4 et 5. Plus précisément, l'équipement 18 est équipé de coulisseaux 28 permettant de guider l'équipement 18 dans les glissières 26 et de guider le flux d'air traversant les perçages 25. La figure 3 représente en perspective un équipement 18 possédant deux coulisseaux 28 assurant chacun le guidage de l'équipement 18 dans une des faces 21 et 24. La figure 4 représente une vue agrandie d'un des coulisseaux 28 dans lequel on distingue des perçages 29 destinés à venir en regard des perçages 25 lorsque l'équipement 18 est en position opérationnelle dans le compartiment utile 17.

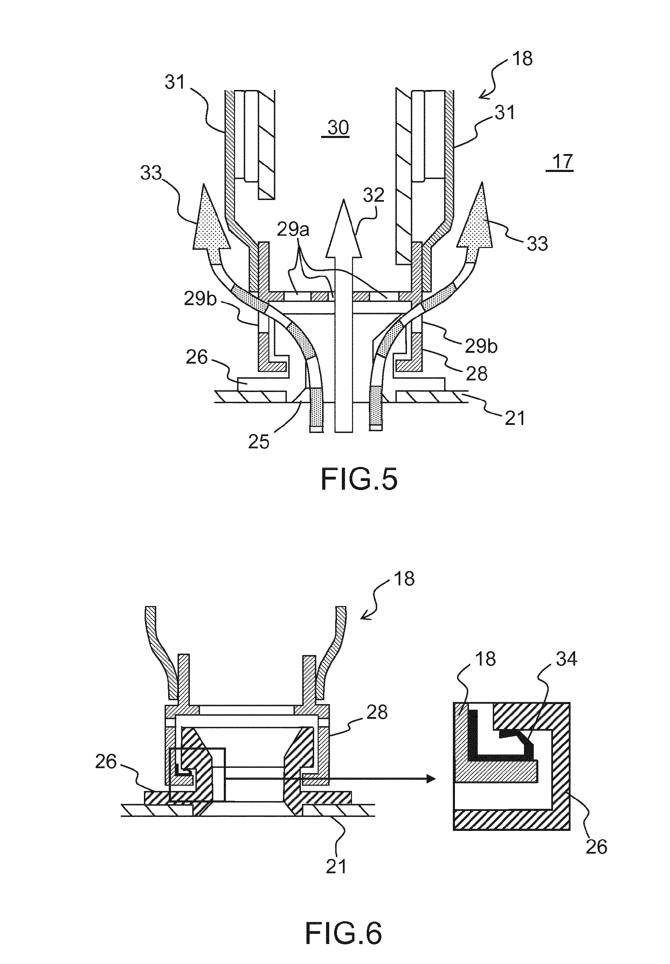

La figure 5 représente un exemple de réalisation d'une glissière 26 et d'un coulisseau 28 associé à cette glissière. La figure 5 est représentée en coupe dans un plan perpendiculaire à la direction 16 d'enfichage de l'équipement 18 dans le compartiment utile 17. La glissière 26 est fixée à la face 21 et forme le perçage 25 permettant à l'air de refroidissement de pénétrer dans le compartiment utile 17. Le coulisseau 28 assure ici la répartition de l'air traversant le perçage 25. Dans cet exemple l'équipement 18 doit être refroidi par un canal interne 30 et le long de ses faces latérales externes 31. Le coulisseau 28 comprend une ou plusieurs lumières 29a permettant de mettre communication le perçage 25 et le canal interne 30. Le flux d'air traversant le perçage 25 et l'une des lumières 29a est matérialisé par une flèche 32. Le coulisseau 28 comprend également une ou plusieurs lumières 29b permettant à l'air circulant dans le perçage 25 de circuler le long des faces 31. Le flux d'air traversant le perçage 25 et les lumières 29b est matérialisé par des flèches 33. De cette façon, la glissière 26 peut être standardisée. La même glissière peut être utilisée pour tous les équipements 18. La répartition de l'air de refroidissement, tant en direction qu'en débit est assuré par les coulisseaux 28 qui sont propres à chacun des équipements 18. Les coulisseaux 28 sont définis en fonction du besoin en refroidissement propre à chaque équipement 18.

Afin d'améliorer l'étanchéité à l'air entre une glissière 26 et un coulisseau 28, il est possible d'intercaler un joint d'étanchéité 34 entre une glissière 26 et le coulisseau 28 correspondant, comme représenté sur la figure 6.

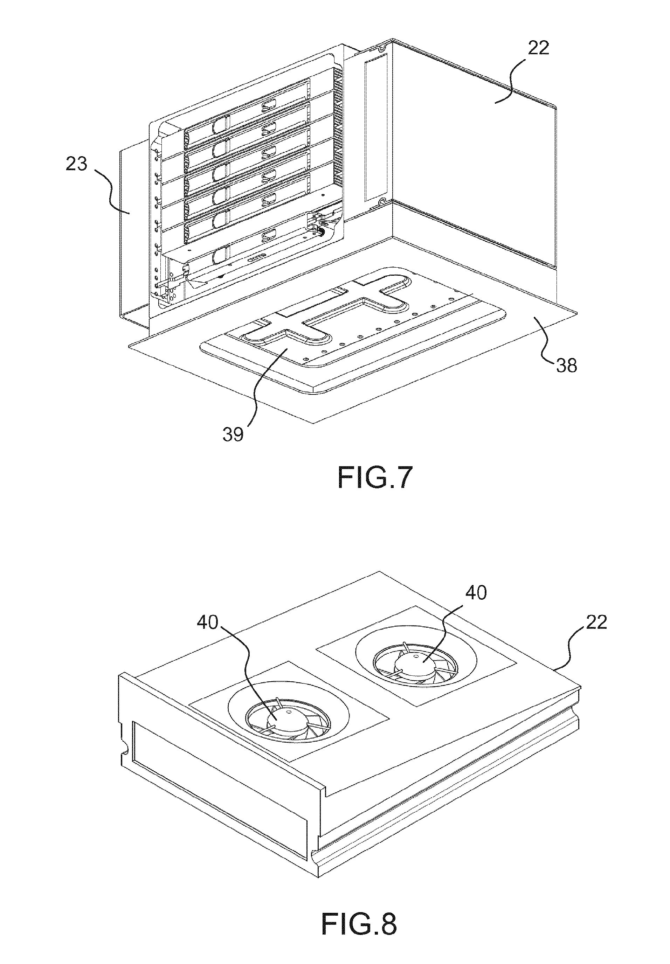

La figure 7 représente une variante de rack 15 dans laquelle le flux d'air provient du dessous du rack 15. Certaines baies aéronautiques, sont équipées d'étagères dans lesquelles circule un canal permettant de délivrer un flux d'air utilisé pour le refroidissement des différents racks équipant la baie. Lorsque le rack 15 est destiné à équiper une telle baie, les moyens de guidage sont adaptés pour permettre le guidage du flux d'air provenant d'une des étagères, dite étagère inférieure 11, vers le compartiment utile 17 du rack 15.

A cet effet, l'entrée d'air de la boîte d'entrée 22 peut être situé sur une face inférieure 27 de la boîte d'entrée 22. Cette entrée d'air est destinée à communiquer avec une ouverture réalisée dans l'étagère 11 afin de prélever de l'air dans le canal de l'étagère 11 pour refroidir les équipements 18 disposés dans le compartiment utile 15.

Le flux d'air suit une circulation en forme de la lettre U :
- Première branche du U dans l'étagère 11,
- Partie centrale du U dans la boite d'entrée 22,
- Deuxième branche du U dans le compartiment utile 17 du rack 15, parallèlement aux équipements électroniques 18.

Les équipements électroniques 18 étant parallèles à l'étagère 11, dans la circulation du flux d'air, les deux branches du U sont parallèles.

A titre d'alternative à l'alimentation en air du rack 15 directement de l'étagère 11 vers la boîte d'entrée 22, les moyens de guidage peuvent comprendre une chaise 38 portant le compartiment utile 15. Cette alternative est représentée sur la figure 3. La chaise 38 assure le guidage du flux d'air provenant de l'étagère inférieure 11 vers le compartiment utile 15. La chaise 38 a par exemple la forme d'un cadre rectangulaire dont la surface reprend la face inférieure 27 de la boîte d'entrée 22 et une face inférieure 39 du compartiment utile. Le cadre rectangulaire délimite un volume fermé situé entre d'une part l'étagère inférieure 11 et d'autre part les faces inférieures 27 et 39 de la boîte d'entrée 22 et une face inférieure 39. Le volume fermé est situé à l'intérieur de la chaise. L'étagère inférieure 11 comprend une ouverture permettant de faire entrer le flux d'air vers le volume interne de la chaise 38. La face inférieure 27 de la boîte d'entrée 22 comprend une ouverture sur le volume interne de la chaise 38 pour faire circuler le flux d'air du volume interne de la chaise 38 vers la boîte d'entrée 22. La présence de la chaise 38 permet de s'adapter à d'éventuelles ouvertures standardisées prévues dans l'étagère 11. La chaise 38 est alors susceptible de recouvrir au moins une ouverture de l'étagère 11. Afin d'améliorer l'étanchéité, il peut être envisagé d'utiliser un joint entre la face inférieure 39 de la chaise 38 et l'étagère 11. Ce joint peut être semblable au joint 34 utilisé entre la glissière 26 et le coulisseau 28. Même en présence de la chaise 38, on retrouve la circulation d'air en forme de U.

Avantageusement, les moyens de guidage du flux d'air comprennent au moins un ventilateur permettant d'entrainer le flux d'air utilisé pour le refroidissement du ou des équipements électroniques 18.

Le ventilateur peut être le moyen principal d'entrainement du flux d'air de refroidissement en l'absence de canal d'air prévu dans l'étagère 11. Il est également possible de mettre en place un ventilateur même lorsque le rack 15 est prévu pour être monté dans une baie 10 délivrant le flux d'air de refroidissement. Le ventilateur permet de conserver un flux d'air en cas de défaillance de la baie dans sa délivrance du flux d'air.

Le ventilateur peut être disposé en amont du compartiment utile 17 dans la boîte d'entrée 22, comme représenté sur la figure 8 où la boîte d'entrée 22 comprend deux ventilateurs 40 ou éventuellement dans la chaise 38 si elle existe. On peut également disposer le ventilateur en aval du compartiment utile 17, par exemple dans la boîte de sortie 23.

## Revendications

1. Rack destiné à équiper une plateforme (10) comprenant deux étagères (11, 12) parallèles disposées entre une face avant (13) et une face arrière (14) de la plateforme (10), le rack (15) étant destiné à être inséré dans la plateforme (10) par translation (16) de la face avant (13) vers la face arrière (14), le rack (15) contenant au moins un équipement électronique (18) s'étendant principalement dans un plan, l'équipement électronique (18) étant disposé dans un compartiment utile (17) du rack (15), l'équipement électronique (18) étant refroidi par convection forcée, **caractérisé en ce que** l'équipement électronique (18) est disposé dans le compartiment utile (15) de telle sorte que son plan principal soit parallèle aux étagères (11, 12), **en ce que** l'équipement électronique (18) peut s'enficher dans le rack (15) selon la même direction que la direction (16) d'insertion du rack (15) dans la plateforme (10) et **en ce que** le rack (15) comprend des moyens de guidage (22, 23, 25, 38, 40) d'un flux d'air utilisé pour le refroidissement de l'équipement électronique (18), le flux d'air pénétrant dans le compartiment utile (17) parallèlement au plan de l'équipement électronique (18) et perpendiculairement à la direction (16) d'insertion du rack (15) dans la plateforme (10).

2. Rack selon la revendication 1, **caractérisé en ce que** les moyens de guidage comprennent une boîte d'entrée (22) recouvrant une première face latérale (21) du compartiment utile (17), et **en ce que** la boîte d'entrée (22) assure le guidage du flux d'air vers le compartiment utile (17).

3. Rack selon la revendication 2, **caractérisé en ce que** les moyens de guidage comprennent des perçages (25) réalisés dans la première face latérale (21) du compartiment utile (17) de façon à permettre le passage du flux d'air de la boîte d'entrée (22) vers le compartiment utile (17), les perçages (25) étant définis en fonction d'une répartition souhaitée du flux d'air dans le compartiment utile (17).

4. Rack selon l'une des revendications précédentes, **caractérisé en ce que** les moyens de guidage comprennent au moins un ventilateur (40) permettant d'entrainer le flux d'air utilisé pour le refroidissement de l'équipement électronique (18).

5. Rack selon l'une quelconque des revendications 2 à 4, **caractérisé en ce que** les moyens de guidage comprennent une boîte de sortie (23) recouvrant une seconde face latérale (24) du compartiment utile (17), et **en ce que** la boîte de sortie (23) assure le guidage du flux d'air quittant le compartiment utile (17).

6. Rack selon l'une des revendications précédentes, **caractérisé en ce qu'**une des étagères, dite étagère inférieure (11), peut délivrer le flux d'air utilisé pour le refroidissement de l'équipement électronique (18) et **en ce que** les moyens de guidage sont configurés pour permettre le guidage du flux d'air provenant de l'étagère inférieure (11) vers le compartiment utile (17) du rack (15).

7. Rack selon la revendication 6, **caractérisé en ce que** les moyens de guidage comprennent une chaise (38) portant le compartiment utile (17), et **en ce que** la chaise (38) assure le guidage d'un flux d'air provenant de l'étagère inférieure (11) vers le compartiment utile (17).

8. Rack selon l'une des revendications précédentes, **caractérisé en ce que** une longueur hors tout (L) de l'équipement électronique (18), mesurée perpendiculairement à la direction d'insertion (16) est supérieure à une hauteur hors tout (H) du rack (15) mesurée perpendiculairement aux deux étagères (12 et 13).

9. Rack selon l'une des revendications précédentes, **caractérisé en ce que** l'équipement électronique (18) comprend un connecteur de fond de panier (19) disposé de sorte que sa direction d'insertion soit la direction d'insertion (16) du rack (15) dans la plateforme (10).
